# EUROPÄISCHE PATENTANMELDUNG

(11) **EP 0 821 456 A1**
(43) Veröffentlichungstag der Anmeldung: **28.01.1998**
(21) Anmeldenummer: 97101200.0
(22) Anmeldetag: 27.01.1997
(51) Int. Cl.: H02B 1/36, B64G 1/42

(54) **Verteilungs- und Schaltungssystem für Mittelspannungsgleichstrom-Netze**

(30) Priorität: 22.07.1996 DE 19629461
(71) Anmelder: Daimler-Benz Aerospace Aktiengesellschaft, 80995 München (DE)
(72) Erfinder: Retat, Ingo, Dr., 28832 Achim (DE); Schmitz, Burkhard, 28199 Bremen (DE); Köhler, Horst, 28279 Bremen (DE); Meyer, Thomas, 28199 Bremen (DE); von Öhsen, Rolf, 28816 Stuhr (DE); Schneegans, Joachim, 28211 Bremen (DE); Tölken, Manfred, 28832 Achim (DE); Weber, Karl-Heinz, Dr., 28215 Bremen (DE); Börchers, Heinz G., 28865 Lilienthal (DE)
(74) Vertreter: Hansmann, Dierk, Dipl.-Ing.

(57) **Zusammenfassung**

Es wird ein modulares Schaltungs-, Sicherungs- und Aufbereitungssystem für Mittelspannungsgleichstrom-Netze beschrieben, daß durch ein modulares Konzept charakterisiert ist und bei dem ein fest installierbares Basisgehäuse für passive Bauelemente und mindestens ein standardisiertes Einschubelement für aktive Bauelemente zum austauschbaren Einsetzen in das Basisgehäuse vorgesehen ist. Dieses Schaltungssystem ist insbesondere zur Verwendung in der Raumfahrt vorgesehen, es kann jedoch auch überall dort eingesetzt werden, wo eine hohe Zuverlässigkeit und lange Lebensdauer bei einfacher Wartung gefordert.

## Beschreibung

Die Erfindung betrifft ein Verteilungs- und Schaltungssystem für Mittelspannungsgleichstrom-Netze, das zum schalten, Absichern, Aufbereiten und Verteilen von mittelhohen Gleichspannungen zum Beispiel im Bereich von 120 Volt vorgesehen ist.

Das System ist bevorzugt zur Anwendung in der Raumfahrt gedacht, es kann jedoch auch sonst überall dort eingesetzt werden, wo eine hohe Zuverlässigkeit bei geringem Wartungsaufwand besonders wichtig ist.

Bei der Entwicklung der internationalen Raumstation Alpha (ISSA) hat man sich für eine Gleichstromversorgung (DC) von 120 V entschieden. Der wesentliche Vorteil gegenüber der bisher üblichen Spannung von 28 V Gleichspannung ist der bei gleicher Verbraucherleistung geringere Strom, der geringere Leitungsquerschnitte ermöglicht. Dadurch sinkt das Gewicht des entsprechenden Kabelbaums, was einen entscheidenden Vorteil für ein Raumfahrtsystem darstellt.

Mit dieser Entscheidung sind aber auch Nachteile verbunden. Insbesondere können einfache Schalter oder Sicherungsautomaten nicht mehr eingesetzt werden, da sich beim Abschalten einer Gleichspannung von 120 V Lichtbögen ausbilden können, die nur langsam verlöschen und mechanische Kontakte möglicherweise zerstören. Zu diesem Zweck werden deshalb Halbleiter-Schalter (z.B. Feld-Effekt-Transistoren) eingesetzt, die über geeignete Schaltungen angesteuert werden. Die bei einer Gleichspannung von 28 V üblichen und bewährten Schalter müssen also durch eine aufwendigere Elektronik ersetzt werden.

Bei Raumfahrtanwendungen muß aber immer auch der Einfluß von Partikel- und Gammastrahlung auf elektronische Bauteile berücksichtigt werden. Diese Strahlung, die einfache Schalter im allgemeinen nicht beeinflußt, kann elektronische Bauteile stören oder sogar zerstören (es können zum Beispiel sogenannte Burn-out-Effekte bei FETs oder Latch-up-Effekte bei Rechnerbauteilen auftreten).

Der Erfindung lag somit die Aufgabe zugrunde, ein Verteilungs- und Schaltungssystem für Mittelspannungsgleichstrom-Netze zu entwickeln, das einfach zu warten ist und eine hohe Zuverlässigkeit und lange Lebensdauer aufweist.

Gelöst wird diese Aufgabe bei einem solchen Verteilungs- und Schaltungssystem dadurch, daß ein fest installierbares Basisgehäuse für passive Bauelemente und mindestens ein Einschubelement für aktive Bauelemente zum austauschbaren Einsetzen in das Basisgehäuse vorgesehen ist.

Ein wesentlicher Vorteil dieser Lösung besteht darin, daß alle aktiven Komponenten leicht und schnell ausgetauscht werden können. Dadurch wird vermieden, daß bei einer Störung oder einem Ausfall des Systems lange Betriebsunterbrechungen auftreten, da keine zeitaufwendige Fehlersuche erforderlich ist, sondern nur das betreffende Einschubelement identifiziert und ausgewechselt werden muß. In dem Basisgehäuse befinden sich nur passive Elemente, wie zum Beispiel Kabelbäume, Verdrahtungen usw., die hei realistischer Betrachtung nicht ausfallen können.

Die Unteransprüche beinhalten vorteilhafte Weiterbildungen des Erfindungsgedankens. Danach kann zum Beispiel das Basisgehäuse eine anwendungsspezifische Verkabelung für das mindestens eine Einschubelement aufweisen.

Das mindestens eine Einschubelement kann ein Klemmensystem zur elektrischen und/oder mechanischen Verbindung mit dem Basisgehäuse aufweisen. Dadurch wird ein guter thermischer Kontakt zwischen dem Einschubelement und dem Basisgehäuse gewährleistet, so daß die in den aktiven Bauelementen entstehende Verlustwärme sicher abgeleitet wird.

Das mindestens eine Einschubelement kann standardisierte Schalt- und Sicherungseinheiten aufweisen, die beim Austausch des Einschubelementes über in dem Basisgehäuse integrierte Codierstecker automatisch auf anwendungsspezifische Kenngrößen umschaltbar sind.

Das mindestens eine Einschubelement kann ferner Schalter aufweisen, mit denen eine manuelle Bedienung und/oder Voreinstellung zusätzlich zu einer Steuerung über eine Datenschnittstelle möglich ist.

Weiterhin können zwei redundante interne Stromversorgungen des Systems vorgesehen sein, die galvanisch voneinander getrennt sind.

Eine dieser Stromversorgungen kann eine Hilfsstromversorgung sein, die nur bei Versagen der Hauptstromversorgung eingeschaltet bzw. belastet wird.

Ein Relaismodul kann zur galvanisch getrennten Versorgung von Verbrauchern aus zwei Stromversorgungen vorgesehen sein.

Das Relaismodul kann dabei dadurch in den stromlosen Zustand geschaltet werden, daß mit Halbleiterschaltern die Versorgungsspannung kurzzeitig abgeschaltet wird.

Schließlich kann die Schaltzeit des Relais über einen Relais-spezifischen Spannungspuls reduziert werden.

Weitere Einzelheiten, Merkmale und Vorteile der Erfindung ergeben sich aus der nachfolgenden Beschreibung einer bevorzugten Ausführungsform anhand der Zeichnung. Es zeigt:
- Figur 1: den mechanischen Aufbau eines erfindungsgemäßen Verteilungs- und Schaltungssystems,
- Figur 2: den mechanischen Aufbau eines standardisierten Einschubelementes **und**
- Figur 3: einen Schaltplan des erfindungsgemäßen Verteilungs- und Schaltungssystems.

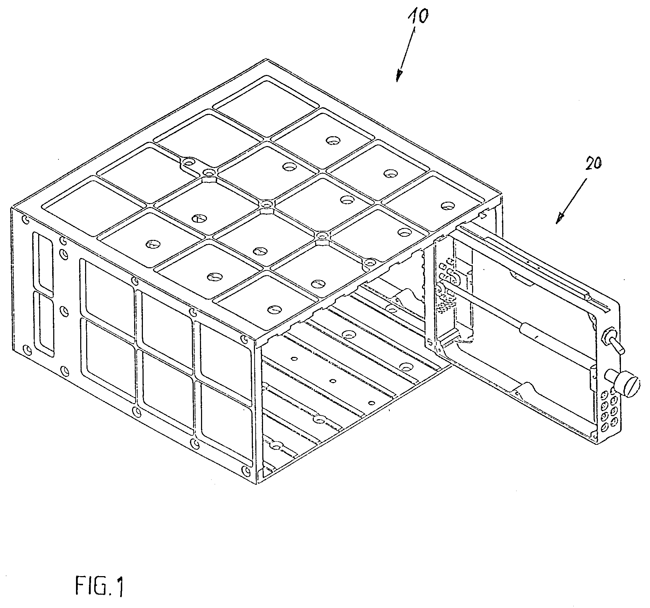

Das erfindungsgemäße System besteht gemäß Figur 1 im wesentlichen aus einem Basisgehäuse 10 sowie mindestens einem vorzugsweise standardisierten Einschubelement 20 zum Einschieben in das Basisgehäuse 10. Das Basisgehäuse selbst enthält nur Stecker und Kabel, die eine hohe Zuverlässigkeit haben, und die darüberhinaus nicht sensitiv auf die Strahlungsumgebung reagieren. Alle elektronischen (aktiven) Komponenten wie Halbleiter-Schalter, Schnittstellen zu einem Steuerrechner, interne Stromversorgungen usw. befinden sich auf den leicht auswechselbaren Einschubelementen 20 (Elektronikmodule ). Im Fehlerfall braucht nur das betreffende Modul von vorne ausgetauscht zu werden. Die Module sind mit Steckern versehen, die beim Einschieben in das Basisgehäuse 10 selbsttätig kontaktieren, so daß der Austausch eines Einschubes auch im Weltraum sehr einfach durchgeführt werden kann.

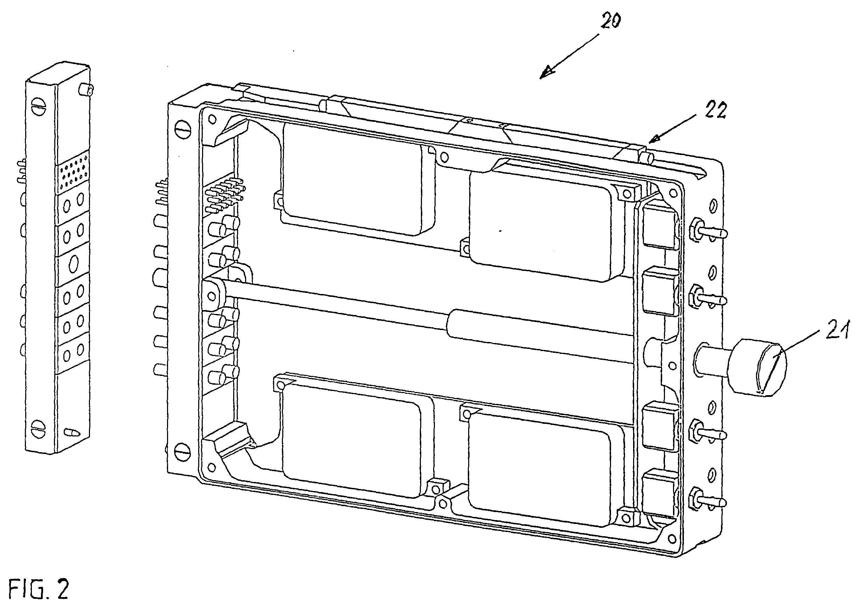

Die Befestigung der Einschubelemente 20 erfolgt gemäß Figur 2 nach zwei Prinzipien: mit einer von vorne (in der Darstellung von rechts) zu drehenden Schraube 21 wird das Einschubelement in das Basisgehäuse hineingezogen, so daß die Steckerkontakte zusammengeführt werden. Eine zweite, ebenfalls von vorne zu bedienende Schraube 22 preßt über eine Keilkonstruktion das Einschubelement gegen den Boden des Basisgehäuses 10. Neben der reinen Befestigung sorgt diese Klemmvorrichtung für einen guten thermischen Kontakt zwischen dem Einschubelement 20 und dem Boden des Basisgehäuses 10. Dadurch wird sichergestellt, daß die in den aktiven Bauelementen entstehende Verlustwärme in ausreichendem Maße von dem Einschubelement über den Boden des Basisgehäuses zum Beispiel an eine Kühlplatte abgeführt werden kann.

Dieses in den Figuren 1 und 2 gezeigte System kann spezifische Anforderungen mit Standard-Einschubelementen erfüllen. Dabei wird nur die Verkabelung im Basisgehäuse 10 anwendungsspezifisch ausgeführt, während für verschiedene Anwendungen gleiche Einschubelemente 20 verwendet werden können. Dadurch wird die Anzahl der benötigten Ersatzteile drastisch reduziert.

Alle Einschubelemente sind auf der Frontseite mit Schaltern versehen, über die sowohl eine manuelle Bedienung möglich ist, als auch ein sogenanntes Presetting durchgeführt werden kann. Dies bedeutet, daß anwendungsspezifisch vorprogrammierbar ist, welche Einheiten unabhängig von einer externen Ansteuerung permanent ein- oder ausgeschaltet sind.

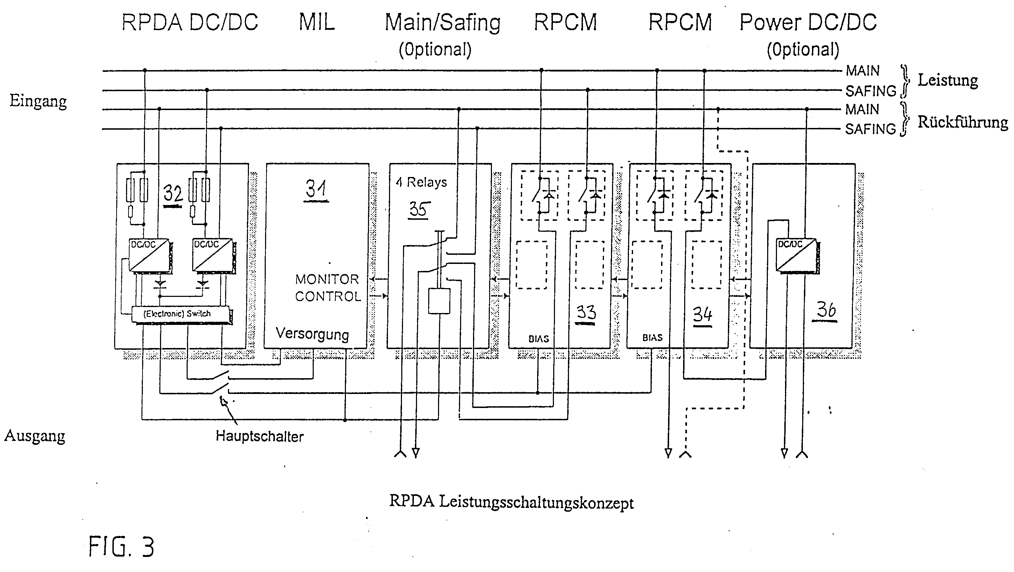

Eine bevorzugte elektrische Ausführung mit einem Schnittstellenmodul sowie internen Stromversorgungs-, Schalt- und Relaismodulen zeigt Figur 3. Für die Ansteuerung durch einen externen Rechner ist ein Modul 31 mit einem 1553 MIL-Bus Interface dargestellt. Wenn für einen spezifischen Anwendungsfall andere Datenschnittstellen benötigt werden, muß nur dieses Modul 31 ausgetauscht werden. Für die interne Stromversorgung der Schaltmodule dient ein Modul 32, das an zwei parallele (und somit redundante) Leitungen mit 120 V Gleichspannung angeschlossen ist. Dieses Modul 32 wird so beschaltet, daß es zunächst nur aus der Hauptversorgung Leistung entnimmt und erst bei einer Funktionsstörung auf die Hilfsversorgung zurückgreift.

Die eigentlichen Schaltmodule 33, 34 enthalten im dargestellten Fall jeweils 4 FET-Schalter mit Sicherungsfunktionen. Dabei werden die Sicherungskenngrößen der Standardmodule beim Einschieben in das Gehäuse über Kodierstecker automatisch an die spezifische Anwendung angepaßt, so daß eine Verwechselung von Sicherungskennwerten ausgeschlossen ist.

Ferner ist in Figur 3 ein Relais-Modul 35 gezeigt, mit dem eine redundante Versorgung der Verbraucher über zwei galvanisch getrennte Busse möglich ist. Die Relais können über die Halbleiter-Schalter stromlos gemacht werden, bevor von der Hauptversorgung auf die Hilfsversorgung umgeschaltet wird. Die Schaltzeiten werden dabei durch eine sogenannte Booster-Schaltung verkürzt, welche die Relais mit einem definierten Überspannungspuls ansteuert. Zusätzlich oder anstelle von Schaltmodulen ist auch der Einsatz eines oder mehrerer Spannungswandlermodule 36 möglich.

Mit dieser Ausführungsform können somit alle anwendungsspezifischen Details über den Kabelbaum im Basisgehäuse 10 festgelegt werden, während alle elektrischen Funktionen über die leicht auswechselbaren Einschubelemente 20 realisiert werden.

## Patentansprüche

1. Verteilungs- und Schaltungssystem für Mittelspannungsgleichstrom-Netze, gekennzeichnet durch ein fest installierbares Basisgehäuse (10) für passive Bauelemente sowie mindestens ein Einschubelement (20) für aktive Bauelemente, zum austauschbaren Einsetzen in das Basisgehäuse (10).

2. System nach Anspruch 1, dadurch gekennzeichnet, daß das Basisgehäuse (10) eine anwendungsspezifische Verkabelung für das mindestens eine Einschubelement (20) aufweist.

3. System nach Anspruch 1 oder 2, dadurch gekennzeichnet, daß das mindestens eine Einschubelement (20) ein Klemmensystem zur elektrischen und/oder mechanischen Verbindung mit dem Basisgehäuse (10) aufweist.

4. System nach einem der vorhergehenden Ansprüche, dadurch gekennzeichnet, daß das mindestens eine Einschubelement (20) standardisierte Schalt- und Sicherungseinheiten (31 - 36) aufweist, die beim Austausch des Einschubelementes (20) über in dem Basisgehäuse (10) integrierte Codierstecker automatisch auf anwendungsspezifische Kenngrößen umschaltbar sind.

5. System nach einem der vorhergehenden Ansprüche, dadurch gekennzeichnet, daß das mindestens eine Einschubelement (20) Schalter aufweist, mit denen eine manuelle Bedienung und/oder Voreinstellung zusätzlich zu einer Steuerung über eine Datenschnittstelle möglich ist.

6. System nach einem der vorhergehenden Ansprüche, gekennzeichnet durch zwei redundante interne Stromversorgungen (32), die galvanisch voneinander getrennt sind.

7. System nach Anspruch 6, dadurch gekennzeichnet, daß eine der Stromversorgungen (32) eine Hilfsstromversorgung ist, die nur bei Versagen der anderen Stromversorgung eingeschaltet und/oder belastet wird.

8. System nach einem der vorhergehenden Ansprüche, dadurch gekennzeichnet, daß ein Relaismodul (35) zur galvanisch getrennten Versorgung von Verbrauchern aus zwei Stromversorgungen vorgesehen ist.

9. System nach Anspruch 8, dadurch gekennzeichnet, daß das Relaismodul (35) dadurch in den stromlosen Zustand geschaltet wird, daß mit Halbleiterschaltern die Versorgungsspannung kurzzeitig abgeschaltet wird.

10. System nach Anspruch 8 oder 9, dadurch gekennzeichnet, daß die Schaltzeit des Relais über einen Relais-spezifischen Spannungspuls reduziert wird.
